# EUROPEAN PATENT APPLICATION

(11) **EP 2 104 047 A1**
(43) Date of publication of application: **23.09.2009**
(21) Application number: 08102782.3
(22) Date of filing: 19.03.2008
(51) Int. Cl.: G06F 17/50

(54) **Router-aided post-placement and routing retiming**

(71) Applicant: Panasonic Corporation, Kadoma-shi Osaka 571-8501 (JP)
(72) Inventor: Domizioli, Dario, Temple Quay, Bristol BS1 6EA (GB); Olgiati, Andrea, Temple Quay, Bristol BS1 6EA (GB)
(74) Representative: Haley, Stephen

(57) **Abstract**

A method of minimising the longest delay path between two logic elements of a circuit placed on a reconfigurable device, each logic element being associated with a register and the reconfigurable device including logic elements and associated registers which are programmed to be transparent, the method comprises the steps of determining a number of possible routing paths for connecting the two logic elements of the circuit through a specific register associated with one of the logic elements, including at least one path which passes through at least one register which is programmed to be transparent and selecting a routing path based on at least one routing path criterion including whether each routing path passes through a register which is programmed to be transparent.

## Description

The present invention is related to optimising the configuration of reconfigurable logic devices by providing an apparatus and method for optimising a hardware design implemented on a programmable architecture.

Certain reconfigurable devices/fabrics are commonly constructed from multiple instances of a single user programmable logic tile. These tiles represent the fundamental building blocks of every logic circuit which is designed using that particular reconfigurable device/fabric.

One of these tiles typically comprises registers associated with logic elements such as Arithmetic Logic Units (ALUs) or multiplexers. In order to perform a specific function, these tiles must be interconnected in a specific way. The information related to how these tiles are interconnected is found in what is known as a netlist.

In order to maximise the performance of a design mapped onto a reconfigurable device/fabric, it is important to find the optimal location of each register cell such that the longest path between any two registers is minimised. This technique of moving the structural location of latches or registers in a digital circuit in order to improve its performance, area, and/or power characteristics is known as "retiming". There are several known approaches to retiming, most of which are based on the use of a retiming algorithm or weighted retiming function.

A first approach to retiming consists of using a retiming algorithm during the synthesis stage of development. At this point, because the netlist has not yet been placed onto the device/fabric, the interconnection delay must first be estimated using a mathematical model. The lengths of the paths between the registers are then calculated using the measured delays of each logic cell and the estimated interconnection delays. Finally, these lengths are used by the retiming algorithm to place the elements onto the fabric. This technique suffers from being entirely dependent on the accuracy of the model used to estimate the interconnection delays. An inefficient or incorrect model can cause the algorithm to choose an inefficient design.

In order to provide a solution to this problem, a technique was developed which involved performing the retiming during the placement stage of the circuit's design. This approach sees the retiming algorithm being executed after each placement iteration, at which point the registers can be rearranged to optimise the paths therebetween. One significant advantage of this technique is that the model used to determine the interconnection delay may incorporate into its calculations a certain amount of placement information, data which would not have been available at the synthesis stage. Thus, although this model will still partially rely on an estimate of the routing delay, it will be more accurate than a model used in the synthesis stage of development. The retiming algorithm that uses this new model will, however, be constrained by the fact that the new arrangement of registers may not be easily placeable, thereby increasing the possibility of invalidating the optimal placement solution found during any one iteration.

In order to increase the accuracy of the retiming process further, a technique has been developed where the register retiming is performed during the routing stage. In this scenario, all actual routing information is known in that the paths between the registers are fixed. Accordingly, this technique does not require the use of a model in order to determine the interconnection delay. At this stage, however, because the register placement cannot be modified, retiming will have little or no impact on the performance of the circuit.

Thus, each of the above techniques suffers particular disadvantages. Although the techniques of retiming during the earlier stages of development provide greater flexibility in terms of register position, they also suffer from having to use approximate timing models. Conversely, retiming at a later stage provides more accurate timing data but limited flexibility due to the difficulties associated with repositioning registers.

Accordingly, there is a clear need for a new method of retiming which provides a high level of timing accuracy and the flexibility to change routing paths after the placement phase.

In order to solve the above problems, the present invention provides a method of minimising the longest delay path between two logic elements of a circuit placed on a reconfigurable device, each logic element being associated with a register and the reconfigurable device including logic elements and associated registers which are programmed to be transparent, the method comprises the steps of:
determining a number of possible routing paths for connecting the two logic elements of the circuit through a specific register associated with one of the logic elements, including at least one path which passes through at least one register which is programmed to be transparent;
selecting a routing path based on at least one routing path criterion including whether each routing path passes through a register which is programmed to be transparent;
calculating, for each respective transparent register through which the selected path is routed, by how much the longest delay between the two logic elements would be reduced by activating the respective transparent register and programming the specific register to be transparent;
determining, based on the results of the calculating step, which, if any, transparent register would maximise the reduction in the longest delay; and
if a transparent register was determined in the determining step, programming the determined transparent register to be active and programming the specific register to be transparent.

Preferably, the at least one routing path criterion further includes the overall delay of each path.

Preferably, the at least one routing path criterion further includes the congestion of each routing path.

Preferably, the method further comprises the step of:
setting the maximum frequency of the circuit based on the maximum delay path.

Preferably, the step of programming the determined transparent register to be active and programming the specific register to be transparent comprises the steps of:
configuring the specific transparent register as a route-through register; and
configuring the determined transparent register as a clocked register.

The present invention further provides an apparatus for minimising the longest delay path between two logic elements of a circuit placed on a reconfigurable device, each logic element being associated with a register and the reconfigurable device including logic elements and associated registers which are programmed to be transparent, the apparatus comprises:
path determining means for determining a number of possible routing paths for connecting the two logic elements of the circuit through a specific register associated with one of the logic elements, including at least one path which passes through at least one register which is programmed to be transparent;
selecting means for selecting a routing path based on at least one routing path criterion, including whether each routing path passes through a register which is programmed to be transparent;
calculating means for calculating, for each respective transparent register through which the selected path is routed, by how much the longest delay between the two logic elements would be reduced by activating the respective transparent register and programming the specific register to be transparent;
transparent register determining means for determining, calculations made by the calculating means, which, if any, transparent register would maximise the reduction in the longest delay; and
programming means for, if a transparent register was determined by the transparent register determining means, programming the determined transparent register to be active and programming the specific register to be transparent.

Preferably, the at least one routing path criterion further includes the overall delay of each path.

Preferably, the at least one routing path criterion further includes the congestion of each routing path.

Preferably, the apparatus further comprises:
setting means for setting the maximum frequency of the circuit based on the maximum delay path.

Preferably, the programming means further comprise:
configuring means for configuring the specific transparent register as a route-through register; and
   configuring means for configuring the determined transparent register as a clocked register.

The reconfigurable device may be a Field Programmable Gate Array (FPGA) circuit.

As will be appreciated, the present invention provides several advantages. For example, because the present invention provides a solution which can be implemented after the placement and routing phase, accurate timing and delay information will be available. The present invention does not involve the physical moving of registers. Instead, the method of the present invention effectively swaps the activation states of registers using their transparency flags. Therefore, because the present invention makes use of unused registers, retiming of the circuit can be accomplished with minimal disruption to the existing registers, thereby resulting in a circuit which has minimised longest delay paths. Accordingly, the present invention provides a retiming method and system which has increased flexibility and effectiveness, thereby resulting in more efficiently optimised logic circuits. These advantages will permit a circuit which has been designed in accordance with the method of the present invention to run at an increased maximum frequency.

An example of the present invention will now be described with reference to the accompanying drawings, in which:
Figure 1 is a schematic diagram representing an example of a netlist;
Figure 2 is an example of a simple reconfigurable device comprising Arithmetic and Logic Units and Multiplexers, Registers, and a Routing Network connecting the elements;
Figure 3 is a schematic diagram representing a possible placement of the netlist of Figure 1 onto the reconfigurable device of Figure 2;
Figure 4 is a schematic diagram of the final routing solution for most paths in the design and of some possible routing solutions for the net from register RX to multiplexer MY in the placed netlist of Figure 2;
Figure 5 is a schematic diagram of the routing solution chosen by the routing algorithm presented in this invention; and
Figure 6 is a schematic diagram of the effect of the post-placement-and-routing retiming of the present invention on the routed netlist of Figure 5.

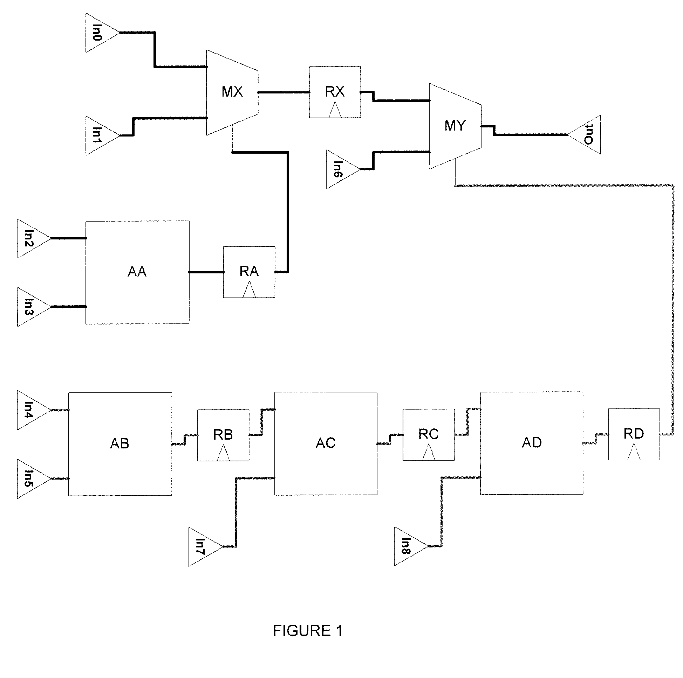

With reference to Figures 1 to 6, the method of the present invention will now be described. Figure 1 shows an example of an application netlist after the synthesis stage. It comprises four 2-input, 1-output Arithmetic Logic Units (AA, AB, AC, and AD), two multiplexers (MX and MY) and five registers (RA, RB, RC, RD and RX). These elements are connected together and to Input/Output (I/O) ports as shown.

The path configuration in Figure 1 is optimal. The logical timing paths in Figure 1 are routed through only one logic element and are therefore ideal. This routing scheme, however, only appears ideal because this is a netlist which has not yet been placed and routed on a reconfigurable device/fabric. Accordingly, the netlist of Figure 1 merely represents the connections which will need to be made and not the actual physical connections which will be made on the reconfigurable fabric. Thus, the netlist provides no information relating to the length of the connections, or the time delays associated with each connection. In this respect, Figure 1 represents the high-level plan of the circuit. In order to be physically realised, the netlist of Figure 1 must be placed and routed onto a physical device/fabric.

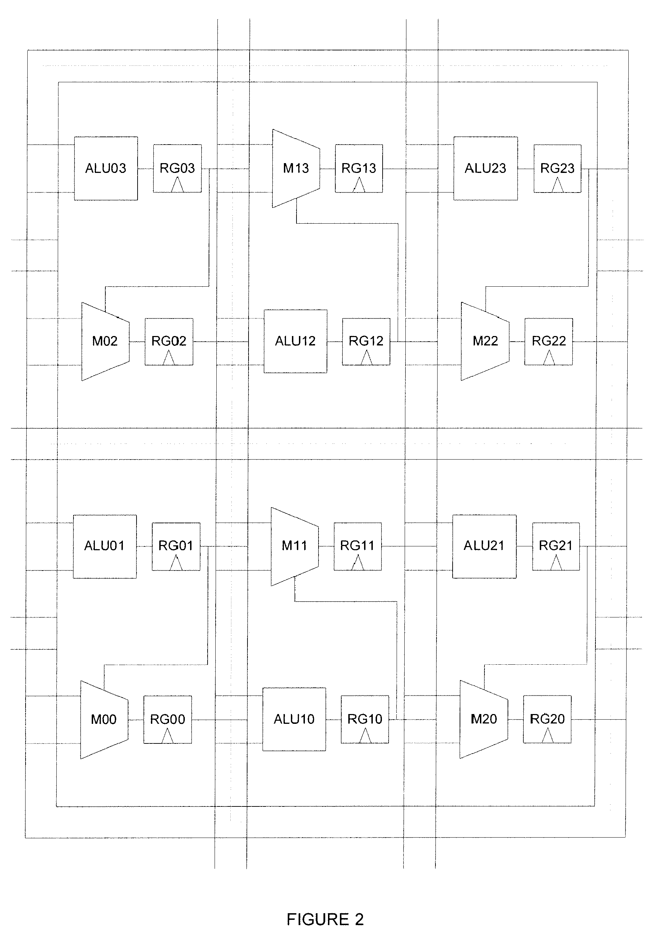

Figure 2 shows a simple reconfigurable architecture comprising logic blocks and an interconnecting routing network. In this example, logic blocks themselves can comprise programmable ALUs and multiplexers. In actual architectures, however, they can also comprise bit selectors, Boolean logic elements and other generally more complicated blocks. The routing network comprises several wires connected by programmable switches (not shown) situated at their intersections. In known reconfigurable architectures, these can be active or passive switches. In this example, and for the purposes of describing the invention, each intersection comprises a switch (not shown) which can either connect any two perpendicular wires or, alternatively, connect every pair of wires that ore on a straight line. It should be noted, however, that different architectures may implement different methods of connecting wires. I/O connections are situated on the perimeter of the array.

The logic elements in this example can also be used as route-through resources. For ALUs, this is achieved by programming them with a "propagate input" function. For multiplexers, this is done by routing a constant signal to their selection input rather than using the input coming from the routing network. Registers are situated on some of the output buses of the above elements. As can be seen from Figure 2, there are no stand-alone registers with respect to the routing network. Rather, there is always a short connection between each one of the registers and the logic element it is driven by.

Each register can be clocked or transparent. This state is specified by a configurable state holder known as the "transparency flag". If the register is clocked, it behaves normally (i.e. it propagates the input value to the output value at every clock cycle). Dissimilarly, if a register is in transparency mode, it propagates the input value without clock latency (i.e. with only a small propagation delay). This means that registers can also be used as route-through resources.

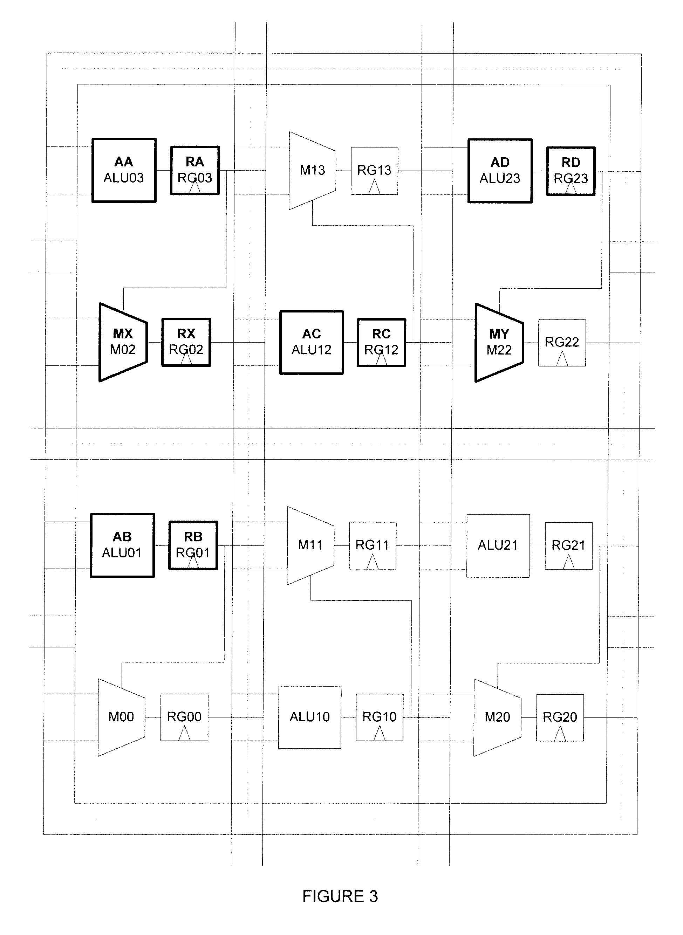

A possible result of the placement stage is shown in Figure 3, where the elements of the netlist of Figure 1 have been placed onto the physical array of Figure 2. The placement shown in Figure 3 is one of several possible placement solutions. Some aspects of this placement solution are beneficial. For example, the multiplexers are placed relatively close to the ALUs which control their selection input, thereby making use of the fast connection that the routing network provides. Also, the diagonal axis in which the chain of ALUs (AB, AC and AD) is connected in the netlist is preserved in the placement. Furthermore, every register is placed very close to the element driving it. As will be appreciated, however, in order to provide these beneficial features, this placement solution does suffer some drawbacks, most notably that of distancing multiplexers MX and MY.

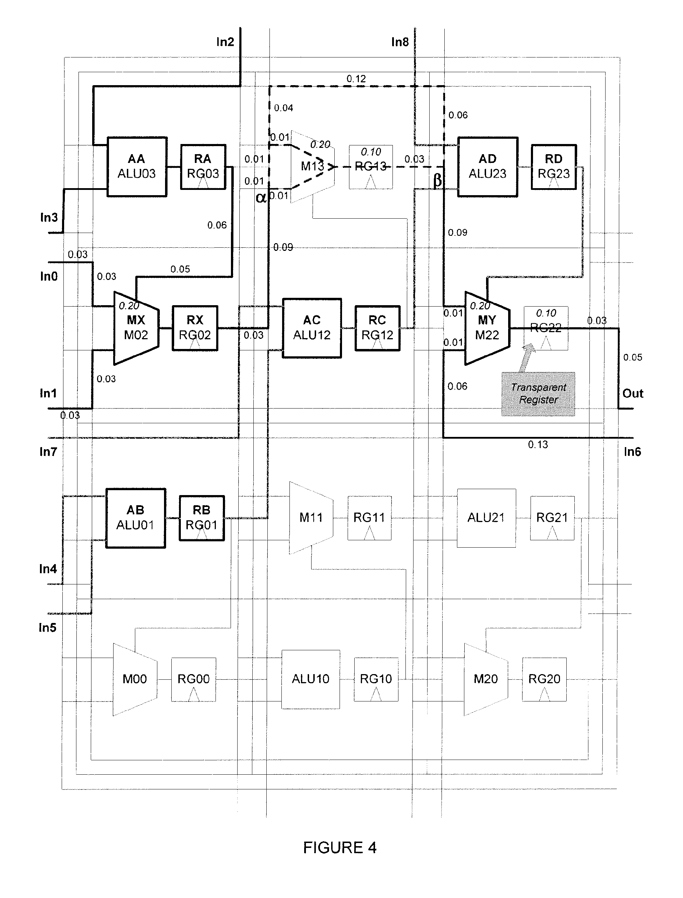

The next stage in the development process, and the first step in the method of the present invention, comprises routing the placed netlist. For most of the nets in the netlist, the solution to the routing problem is trivial. Accordingly, no congestion is found. Figure 4 shows a possible incomplete routing scenario, comprising three alternatives for the path from register RX to multiplexer MY.

The path from RX to MY can pass through either inputs of the multiplexer M13 (and then through register RG13, which can be set as transparent) or be routed around the multiplexer block altogether. This is allowed because, as explained above, the logic elements and the registers can be used as route-through resources. Figure 4 shows the delay values for every segment of wire and every logic element in this example.

There are several criteria by which routing algorithms select a path. Typically, the selection depends on the delay across the paths (i.e. the lowest delay path is selected to maximize performance) and the number of congested wires (i.e. congestion is to be avoided). The method of the present invention provides a modified routing algorithm which makes use of a new, additional criterion for choosing optimal paths. The present invention further provides a router which implements the modified routing algorithm by selecting a path which, despite having a longer delay and providing no further benefit to wire congestion, passes through at least one transparent register that can be exploited in the retiming phase.

In the example of Figure 4, the disadvantage with the proposed paths is that all of the possible solutions shown result in relatively long timing paths from register RX to the output port. This is because every segment of the wire used to connect the elements has a resistance and a capacitance contributing to the signal propagation delay, and every active logic element traversed has its own propagation delay. The delays shown in Figure 4 are stated in non-specific units of time. As will be appreciated by the skilled reader, depending on the hardware implementation of the reconfigurable device, the actual length of this non-specific unit may vary.

A standard timing-based router would choose the solution that produces the least amount of delay, which is the path going around the multiplexer block. As shown on figure 4, this path has a total delay of 0.84 units (i.e. 0.03 + 0.09 + 0.01 + 0.01 + 0.04 +0.12 + 0.06 + 0.09 + 0.01 +0.2 + 0.1 + 0.03 + 0.05), from RX to the output port. Consequently, the performance of the circuit is affected by this relatively long connection.

In order to solve this problem, the method of the present invention makes use of the synergy between the modified routing algorithm and a retiming algorithm applied after the routing stage.

The router in accordance with the present invention first examines the various paths between RX to MY. In so doing, the router determines that the difference between these paths is localised in the route which stretches from switch α to switch β. As explained above, the example of Figure 4 shows three routing possibilities. The net can be routed around the multiplexer block, through one of the multiplexer inputs or through the other of the multiplexer inputs. Routing it around the multiplexer results in a delay of 0.24 units from switch α to switch β, while routing it through the multiplexer can result in a delay of either 0.34 units or 0.36 units, depending on the chosen input.

The router of the present invention then detects that the paths which go through the multiplexer block contain a pass-though register (i.e. register RG13). This detection step provides a significant advantage in that, although the paths which pass through the pass-through register may not be optimal in terms of timing, the transparent register RG13 within these paths may provide further advantages during the retiming phase.

The next step is to analyse the possible paths and determine the most convenient for routing the signal. Although the pass-through register situated on a path may be useful at some further point during the routing process, in some cases, the additional delay needed to reach the register will be too high. The router in accordance with the present invention therefore uses a criterion to decide whether to accept a relatively long path comprising one or more pass-through registers. This criterion could be any mathematical or logical criterion for example, a simple cost function (i.e. if the difference in delay between the shortest path and the shortest of the paths comprising at least on pass-through register is below a pre-defined threshold, the path is accepted). The threshold can be a fixed number or a "tolerance" (e.g. a percentage of a specific delay) which can be fixed by a user. The user can therefore decide how much delay he is willing to risk for the possibility of benefiting from the use of a pass-through register. Other factors, such as the number of pass-through registers a path may comprise, may also be factored into the analysis step.

An example of the above will now be described with reference to the example of Figure 4, where a delay threshold of 0.15 time units has been chosen by a user. Because the routing paths which pass through register RG13 are only slightly longer than the alternative option (i.e. 0.10 or 0.12 time units, respectively), these routing paths will be accepted by the router of the present invention. Of the two paths which pass through the register, the one which produces a delay of 0.34 units is the shortest. Accordingly, the method of the present invention will ultimately choose the path which has a delay of 0.34 units.

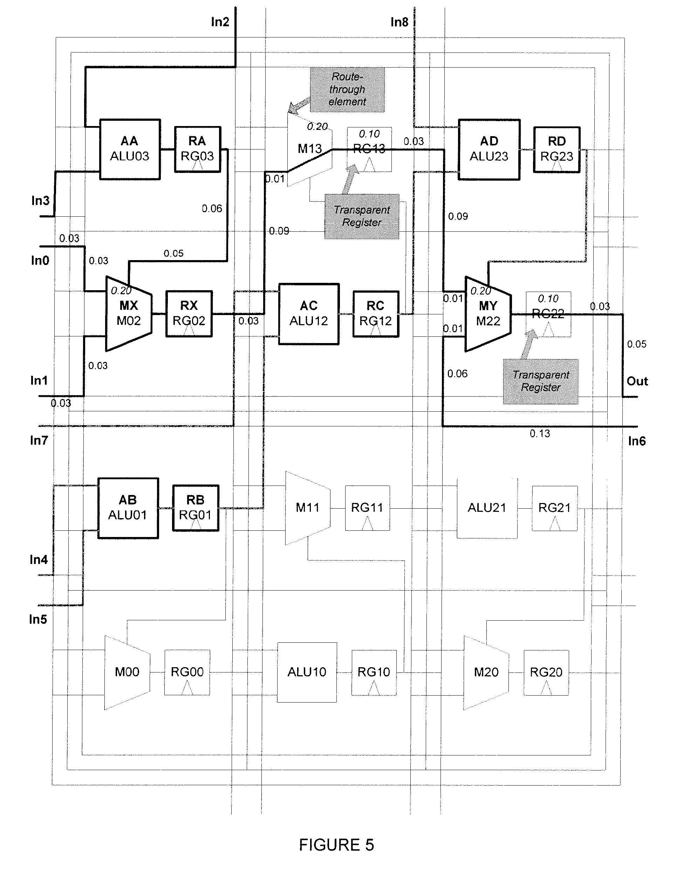

Figure 5 shows the final routing selected by the router of the present invention. The total delay from register RX to the output port is 0.94 units. At this stage, known retiming algorithms suffer significant constraints in that they can only insert or move elements to a limited set of valid locations.

Dissimilarly, in the method of the present invention, performing a "move" of a register means swapping the "transparency" state holder of a pair of registers, so that one of them is "demoted" to being a transparent route-through register, and the other one is "promoted" to be a clocked register. Likewise, "inserting" a register means switching its "transparency" flag and promoting it to be a clocked register.

Thus, all transparent registers on the selected path are valid additional locations for use in the retiming algorithm. Because the method of the present invention comprises a step of specifically seeking out transparent registers which can be included in routing paths, the method of the present invention will, on average, have access to a wide range of options relating to which transparent registers it can use in subsequent retiming steps.

The next step of the method is that of calculating the optimal configuration of register locations that will preserve the functionality of the netlist and minimise the longest delay path in the netlist. As will be appreciated, the information which the algorithm uses to calculate the values in this step is accurate, having been extracted after the placement and routing phases. Moreover, the resistance and capacitance of the wires connecting the logic elements is known. Finally, the signal propagation delay through the cells is known, as it can, for example, be looked up in a hardware characterisation database. Accordingly, the delay across each path will be accurately determined rather than being estimated.

In the example of Figure 5, only one "move" is necessary to reach the optimal configuration of registers. As can be seen from Figure 5, the ideal "move" is that of activating RG13 to be RX. As can clearly be seen from Figure 5, this configuration will minimise the longest delay path in the system. Accordingly, the method of the present invention will activate the transparency state holder of RG02, thereby "demoting" it to a transparent register and will deactivate the transparency state holder of RG13, thereby "promoting" it to a clocked register. The state of register RG22 will remain unchanged.

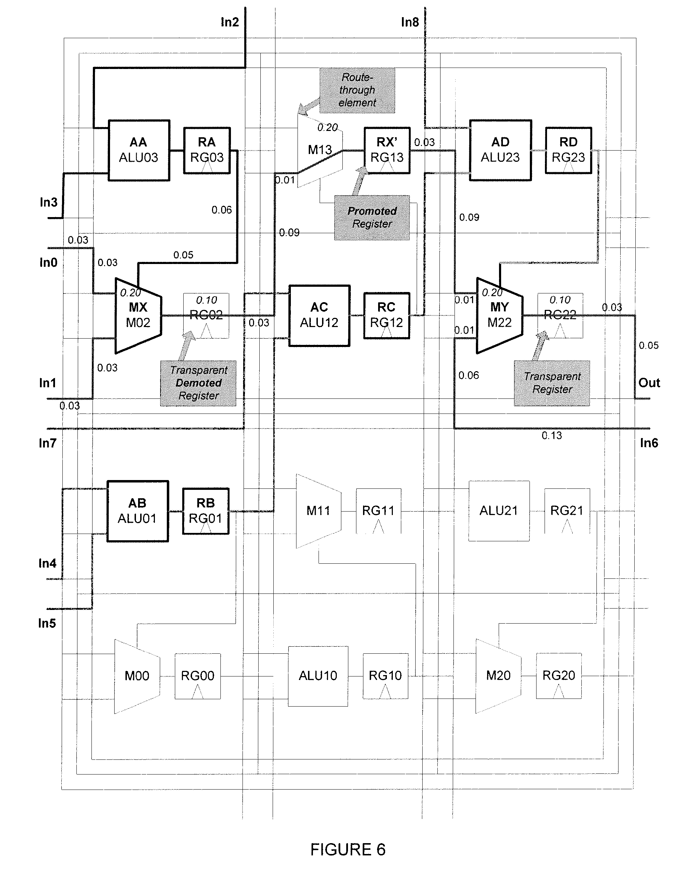

Figure 6 illustrates the final result produced by the method of the present invention. As can be seen, before the retiming phase was applied, the longest timing path was the one from RX, through MY, to the output port. The route selected using the method of the present invention was 0.94 time units in length, while a standard routing algorithm would have selected a path having a longest delay path of 0.84 time units. A known retiming algorithm applied to the circuit by a standard router would not however have been able to make use of any unused registers because there would not have been enough valid locations available, while the retiming phase performed in accordance with the present invention had access to an additional register location which was advantageously used in the final routing path.

As a result of executing the method of the present invention, the longest path is the one from RA, through MX, to RX. This route is 0.74 units in length. This reduced delay permits the maximum clock frequency of the design to be increased. This represents a 27% improvement in performance over the result of a basic routing step and a 13.5% improvement in performance over the result achieved with a standard routing algorithm.

## Claims

1. A method of minimising the longest delay path between two logic elements of a circuit placed on a reconfigurable device, each logic element being associated with a register and the reconfigurable device including logic elements and associated registers which are programmed to be transparent, the method comprising the steps of:
determining a number of possible routing paths for connecting the two logic elements of the circuit through a specific register associated with one of the logic elements, including at least one path which passes through at least one register which is programmed to be transparent;
selecting a routing path based on at least one routing path criterion including whether each routing path passes through a register which is programmed to be transparent;
calculating, for each respective transparent register through which the selected path is routed, by how much the longest delay between the two logic elements would be reduced by activating the respective transparent register and programming the specific register to be transparent;
determining, based on the results of the calculating step, which, if any, transparent register would maximise the reduction in the longest delay; and
if a transparent register was determined in the determining step, programming the determined transparent register to be active and programming the specific register to be transparent.

2. The method of claim 1, wherein the at least one routing path criterion further includes the overall delay of each path.

3. The method of any of claim 1 or 2, wherein the at least one routing path criterion further includes the congestion of each routing path.

4. The method of any of the preceding claims further comprising the step of:
setting the maximum frequency of the circuit based on the maximum delay path.

5. The method of any of the preceding claims, wherein the step of programming the determined transparent register to be active and programming the specific register to be transparent comprises the steps of:
configuring the specific transparent register as a route-through register; and
configuring the determined transparent register as a clocked register.

6. The method of any of the preceding claims, wherein the reconfigurable device is a Field Programmable Gate Array (FPGA) circuit.

7. An apparatus for minimising the longest delay path between two logic elements of a circuit placed on a reconfigurable device, each logic element being associated with a register and the reconfigurable device including logic elements and associated registers which are programmed to be transparent, the apparatus comprising:
path determining means for determining a number of possible routing paths for connecting the two logic elements of the circuit through a specific register associated with one of the logic elements, including at least one path which passes through at least one register which is programmed to be transparent;
selecting means for selecting a routing path based on at least one routing path criterion, including whether each routing path passes through a register which is programmed to be transparent;
calculating means for calculating, for each respective transparent register through which the selected path is routed, by how much the longest delay between the two logic elements would be reduced by activating the respective transparent register and programming the specific register to be transparent;
transparent register determining means for determining, calculations made by the calculating means, which, if any, transparent register would maximise the reduction in the longest delay; and
programming means for, if a transparent register was determined by the transparent register determining means, programming the determined transparent register to be active and programming the specific register to be transparent.

8. The apparatus of claim 7, wherein the at least one routing path criterion further includes the overall delay of each path.

9. The apparatus of any of claim 7 or 8, wherein the at least one routing path criterion further includes the congestion of each routing path.

10. The apparatus of any of the preceding claims further comprising:
setting means for setting the maximum frequency of the circuit based on the maximum delay path.

11. The apparatus of any of the preceding claims, wherein the programming means further comprise:
configuring means for configuring the specific transparent register as a route-through register; and
configuring means for configuring the determined transparent register as a clocked register.

12. The apparatus of any of the preceding claims, wherein the reconfigurable device is a Field Programmable Gate Array (FPGA) circuit.
